# EUROPEAN PATENT APPLICATION

(11) **EP 1 209 748 A1**
(43) Date of publication of application: **29.05.2002**
(21) Application number: 01309625.0
(22) Date of filing: 14.11.2001
(51) Int. Cl.: H01L 27/12, G02F 1/1362, G02F 1/1368

(54) **TFT display matrix having pixel electrodes formed simultaneously with the TFT channel**

(30) Priority: 15.11.2000 JP 2000347796; 30.05.2001 JP 2001162445; 30.05.2001 JP 2001161830
(71) Applicant: MATSUSHITA ELECTRIC INDUSTRIAL CO., LTD., Kadoma-shi, Osaka 571-8501 (JP)
(72) Inventor: Ogawa, Kazufumi, Nara-shi, Nara 630-8101 (JP)
(74) Representative: Dempster, Benjamin John Naftel

(57) **Abstract**

By imparting conductivity to specified regions of a semiconductor material film 4 formed over a substrate 2, the semiconductor material film 4, in addition to being processed into channel portions (active layers) 4a, source portions 4b, and drain portions 4c of TFTs, is processed into conductive elements containing pixel electrodes 10 connected to the drain portions 4c. Regions composed of an intrinsic semiconductor to which impurities have not been added serve as the active layers (channel regions) of the TFTs and regions to which impurities have been added serve as conductive, elements. When transparent electrodes are formed, an oxide semiconductor is used.

## Description

The present invention relates to a thin film transistor (TFT) array, in which a plurality of TFTs is arranged in a matrix, for use in flat display panels such as liquid crystal display panels and electroluminescent (EL) display panels. More specifically, the present invention relates to an improvement for simplifying a method of producing the same.

Among display panels, active matrix display panels, in which thin film transistors (TFTs) utilizing amorphous silicon, polycrystalline silicon, or the like serve as switching elements for controlling the pixels, rather than simple matrix display panels, have become wide-spread.

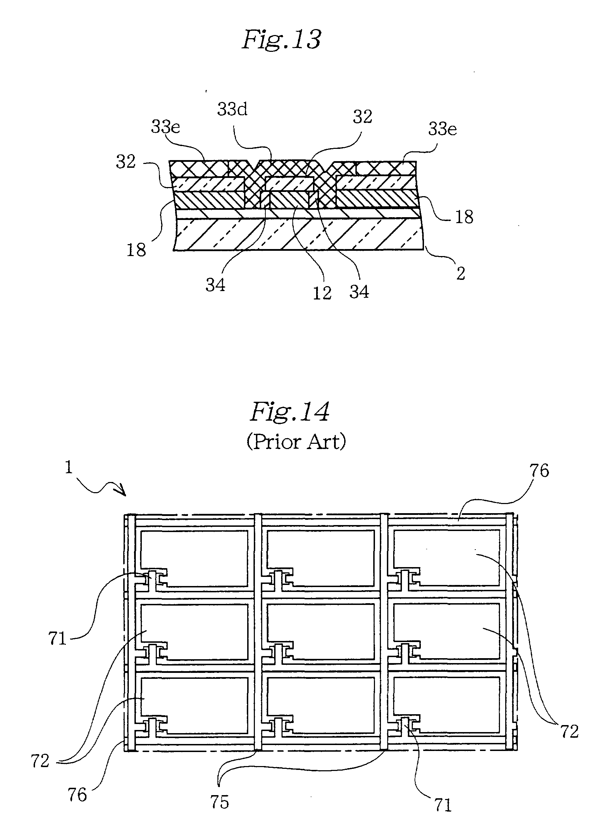

An example of a TFT array is shown in Fig. 14. On an insulating substrate, thin film transistors (TFTs) 71 are arranged in a matrix. Source signal lines 75, each connected to source regions of the TFTs 71 of a given column, supply source signals from a driver circuit (not shown in figure) to the TFTs 71 Gate signal lines 76, each connected to gate electrodes of the TFTs 71 of a given row, supply gate signals from a driver circuit (not shown in figure) to the TFTs 71. Pixel electrodes 72 are connected to the drain regions of the TFTs 71.

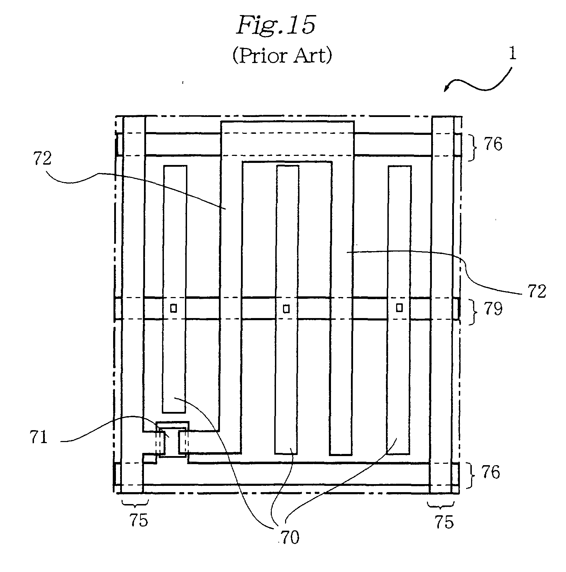

On the surface of the TFT array for a liquid crystal display panel, an orientation film for controlling the initial orientation of liquid crystal molecules is formed. The liquid crystal display panel is such that the TFT array and a counter substrate provided with a counter electrode on a surface thereof are arranged to face one another with a liquid crystal layer sandwiched therebetween. Liquid crystal display panels can be broadly classified into three categories: the transmissive-type, which utilizes light from a back light for display, the reflective-type, which reflects incident light and utilizes this light for display, and the transflective-type, which is provided with the functions of both the transmissive-type and the reflective-type. As is shown in Fig. 15, in a so-called IPS (in-plane switching) type liquid crystal display panel, pixel electrodes 72 and counter electrodes (common electrodes) 70 are comb-shaped and are disposed on a TFT array 1.

In electroluminescent (EL) display panels, a light-emitting layer and a counter electrode are disposed so as to be stacked on pixel electrodes of a TFT array.

Conventionally, a TFT array has been produced in, for example, the following manner.

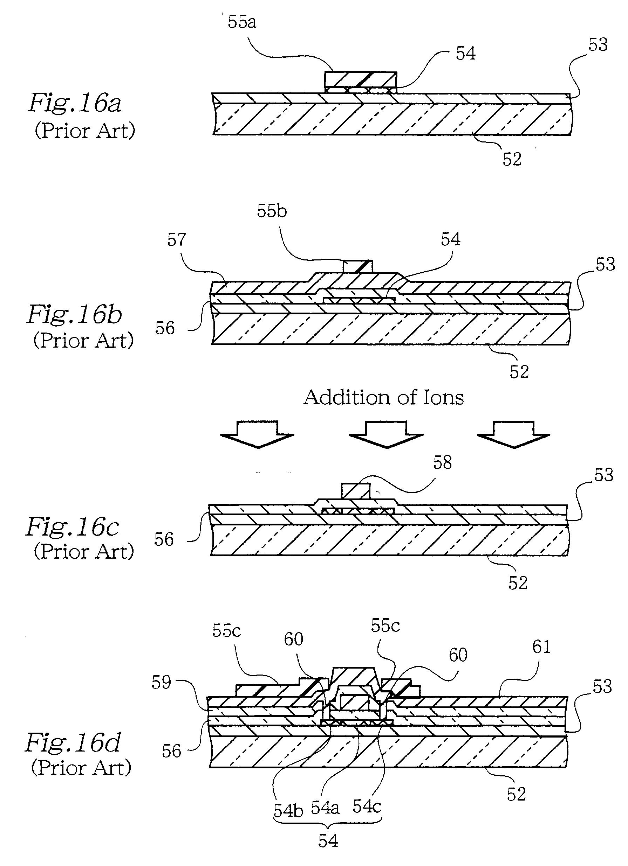

As shown in Fig. 16a, an undercoat layer 53 composed of silicon oxide is formed over a surface of a substrate 52 composed of glass, and subsequently, a semiconductor material film 54 composed of silicon is formed and processed into individual sections to form each TFT by carrying out etching using a mask 55a having a specified shape.

As is shown in Fig. 16b, an insulating layer 56 composed of silicon oxide is then formed over the substrate 52 having the semiconductor material film 54 formed thereon, and a conductive layer 57 is formed. By carrying out etching using a mask 55b having a specified pattern, the conductive layer 57 is processed into gate signal lines (not shown in the figure) and a plurality (not shown) of gate electrodes 58. As shown in Fig. 16c, a p-type or n-type impurity is added to the semiconductor material film 54 using the gate electrodes 58 as a mask to form a plurality (not shown) of channel regions (active layers) 54a, source regions 54b, and drain regions 54c in the semiconductor material film 54.

After an insulating layer 59 is formed so as to cover that formed over the surface of the substrate 52, as shown in Fig. 16d, contact holes 60 are formed so as to pass through the portions of the insulating layers 56 and 59 that are directly above the source regions 54b and the drain regions 54c using a mask (not shown in the figure) having a specified pattern, and a conductive layer 61 is formed over the surface of the substrate 52.

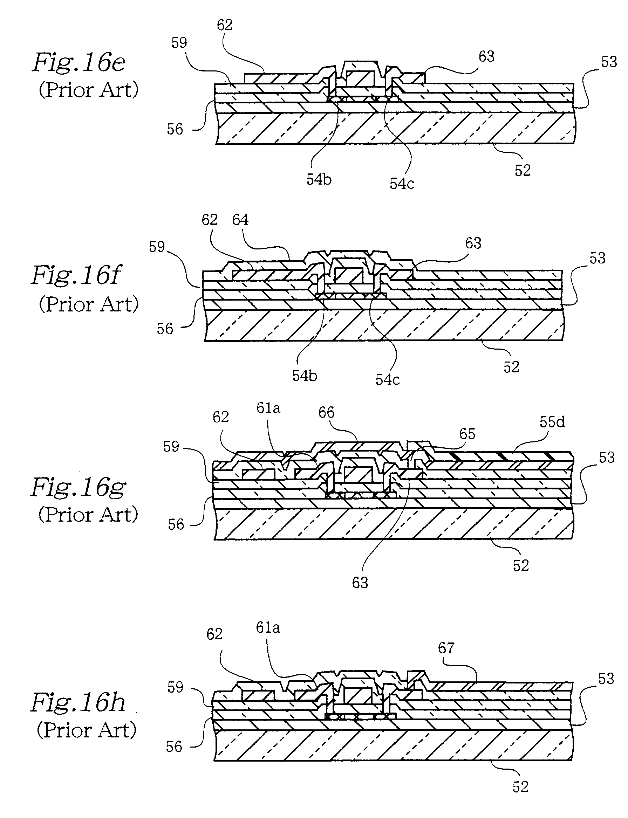

The conductive layer 61 is processed using a mask 55c having a specified pattern, and as shown in Fig. 16e, a plurality (not shown) of source signal lines 62 connected to the source regions 54b, and a plurality (not shown) of contact layers 63 connected to the drain regions 54c are formed. These contact layers are used as the pixel electrodes in TFT arrays in which it is suitable that the pixel electrodes be opaque, such as in reflective-type liquid crystal display panels. The contact layers are also used for the pixel electrodes intended for reflective display in an array for a transflective-type liquid crystal display panel.

In an array that calls for transparent pixel electrodes, an insulating layer 64 is formed over the surface of the substrate 52 as shown in Fig. 16f. As is shown in Fig. 16g, a plurality (not shown) of contact holes 65 exposed to the contact layers 63 are formed in the insulating layer 64, and after a conductive film 66 composed of a transparent conductive material such as indium tin oxide (ITO) is formed, the conductive film 66 is processed, as is shown in Fig. 16h, into a plurality (not shown) of pixel electrodes 67 by carrying out etching using a mask 55d having a specified pattern.

After the pixel electrodes are formed in the manner described above, a passivation layer composed of silicon nitride, for example, is formed over the surface of the substrate 52, and a top-gate TFT array is thus obtained.

In the case of a bottom-gate TFT array, after the gate signal lines and the gate electrodes are formed, a semiconductor material film, separated by an insulating layer, is formed. Thus, yet another mask is needed for the addition of impurities.

As is described above, in the production of a conventional TFT array, it is necessary that a mask having a specific pattern be employed for the addition of impurities and the like in the processing of a semiconductor material film, the forming of gate electrodes and gate signal lines, the forming of contact holes, the forming of source signal lines, and the forming of pixel electrodes, respectively. In other words, in the production of a TFT array, about 5 to 8 masks have generally been used.

Thus, there is a need for a reduction in the number of masks and a simplification of the steps.

In Japanese Unexamined Patent Publication No. 62-502361, a production method for a diode array is, for example, proposed that makes it possible to reduce the number of photomasks employed to two. However, as is, the technique cannot be applied to a production method for a TFT array. Moreover, diodes are inherently inferior to TFTs in terms of characteristics for high speed driving.

It is an object of the present invention to solve the problems described hereinbefore and to provide a simple process for producing a TFT array.

According to the present invention, by imparting conductivity to specified regions of a semiconductor material film formed over a substrate, the semiconductor material film, in addition to being processed into channel portions (active layers), source portions, and drain portions of TFTs, is processed into conductive elements containing pixel electrodes connected to the drain portions. The pixel electrodes are integrally formed with the drain portions.

Fundamentally, the semiconductor material film comprises an intrinsic semiconductor without impurities, in other words a so-called i-type semiconductor. In the regions to be processed into conductive elements of the semiconductor material film, a specified element that is an element different from that which the semiconductor material film comprises is added to serve as a p-type or n-type impurity for imparting conductivity. The added impurity provides carriers that contribute to the electrical conductivity of the layer. Thus, the regions to which the impurity has been added show a high conductivity. In other words, it is possible to process specified regions of the semiconductor material film into conductive elements. The regions of the semiconductor material film to which impurities have not been added function as the channel portion of each TFT.

In adding the impurities, a known technique may be employed such as thermal diffusion, laser doping, plasma doping, ion injection, or the like. For example, by thermal diffusion in which conductive elements such as already formed source signal lines or the like serve as the source of the impurity, one of its constituent elements can be diffused into the semiconductor material film.

The channel portions may contain impurities at a low concentration of approximately 10¹² atoms/cm². When impurities are diffused into the channel portions to a low concentration, leak current between the source portions and the drain portions is small.

A semiconductor material film is processed into a shape corresponding to that of the elements to be formed before or after conductivity is imparted thereto. Alternatively, it is possible to form each of the elements of the TFTs without processing the shape of the semiconductor material film formed over the substrate. Because of the fact that regions of the semiconductor material film to which impurities have not been added do not show conductivity when not under the presence of an electric field, these regions also function as insulating elements as a result of their relative position with respect to conductive elements such as electrodes. Therefore, the semiconductor material film, in addition to being processed into channel portions and conductive elements, can be processed into insulating elements. The regions for the pixel electrodes to which conductivity has been imparted are separated from one another by regions directly above or below signal lines, conductivity having not been imparted to these regions. The width of the regions directly above or directly below the signal lines is set to be larger than the width of the signal lines themselves so as to secure offset regions, and thereby, insulation of the pixel electrodes from one another is ensured.

When oxide semiconductors such as zinc oxide (ZnO), zinc-magnesium oxide (MGₓZn₁₋ₓO), zinc-cadmium oxide (CdₓZn₁₋ₓO), cadmium oxide (CdO), or the like are employed for the semiconductor material film, a transparent conductive element, for example a transparent pixel electrode, is obtained. It is also possible to use a semiconductor material film composed of silicon.

As the impurity for imparting conductivity to the semiconductor material film, group III elements (B, Al, Ga, In, and Ti) for a p-type impurity or group V elements (N, P, As, Sb, and Bi) for an n-type impurity may be employed. For the conductive elements, regions having a high impurity concentration, for example having an impurity concentration of approximately 10¹⁷ atoms/cm², are formed.

Conventionally, a semiconductor material film is processed into semiconductor layers each having a channel region, a source region, and a drain region, extraction electrodes are formed so as to be connected to the source regions and the drain regions, respectively, and source signal lines and pixel electrodes are formed so as to be connected to the extraction electrodes, respectively. In other words, the semiconductor layers of the TFTs and the pixel electrodes are composed of different materials and are formed by different processes.

On the other hand, according to the present invention, the semiconductor layers of the TFTs and the pixel electrodes are composed of substantially the same material and are integrally formed in the same step. Forming the semiconductor layers and the pixel electrodes by processing each with the same mask greatly simplifies the formation process. In addition, the channel portions and the source signal lines are connected by single conductive elements (the source portions) that comprise the same semiconductor material as the channel portions. The need to form extraction electrodes and contact holes is thus eliminated. In other words, according to the present invention, the number of films formed and the number of masks employed in the pattering of the film is significantly reduced.

When the integrally formed semiconductor layers and pixel electrodes are composed of a transparent, oxide semiconductor, a high numerical aperture for the pixels is obtained. Thus, according to the present invention, the production process is simplified, and a display device is obtained that is capable of realizing an even brighter display.

When it is necessary that the pixel electrodes be light reflective, the semiconductor material film may be processed into a shape corresponding to the channel portions, source portions, and drain portions, and the electrodes for reflection may be formed at, for example, the same time that the source signal lines are formed. The reflective electrodes may be composed of a metal that has a low electrical resistance and that is light reflective, such as aluminum and its alloys.

In a TFT array of a so-called transflective-type liquid crystal display panel in which both transparent electrodes and reflective electrodes are provided as the pixel electrodes, reflective electrodes similar to those described above may be formed so as to be connected to transparent electrodes formed by the processing of the semiconductor material film.

TFTs employed in the present invention may be used, not only as the switching elements of pixels in a display panel, but also as the switching elements in a driver circuit for the TFTs of the display panel. For example, in the vicinity of the array substrate, TFTs having the same construction as that of the TFTs used as switching elements may be disposed as the switching elements of the driver circuit for the source signal lines or the gate signal lines.

For a more complete understanding of the present invention, and the advantages thereof, reference is now made to the following descriptions taken in conjunction with the accompanying drawings, in which:
Fig. 1a is a schematic longitudinal section showing the essential part of a TFT array of the present invention, and Fig. 1b is a plan view of the same;
Figs. 2a-2g are schematic longitudinal sections of the essential part showing the state of the substrate at each stage of a production process of the TFT array;
Fig. 3 is a schematic longitudinal section showing the essential part of the same TFT array;
Figs. 4a and 4b are schematic longitudinal sections of the essential part showing the state of the substrate at each stage of a production process of another TFT array of the present invention;
Fig. 5 is a schematic longitudinal section showing the essential part of yet another TFT array of the present invention;
Fig. 6 is a schematic longitudinal section showing the essential part of still another TFT array of the present invention;
Fig. 7 is a schematic longitudinal section showing a liquid crystal display panel that utilizes a TFT array of the present invention;
Fig. 8 is a schematic longitudinal section showing an electroluminescent display panel that utilizes a TFT array of the present invention;
Fig. 9 is a schematic longitudinal section showing the essential part of still another TFT array of the present invention;
Figs. 10a-10f are schematic longitudinal sections of the essential part showing the state of the substrate at each stage of a production process of the same TFT array;
Fig. 11a is a schematic longitudinal section showing the essential part of still another TFT array of the present invention, and Fig. 11b is a plan view of the same;
Figs. 12a-12d are schematic longitudinal sections of the essential part showing the state of the substrate at each stage of a production process of the same TFT array;
Fig. 13 is a schematic longitudinal section showing an essential part of the same TFT array;
Fig. 14 is a schematic plan view showing the construction of a TFT array;
Fig. 15 is a schematic plan view showing the essential part of a TFT array that is utilized in an IPS-type liquid crystal display panel; and
Figs. 16a-16h are schematic longitudinal sections of the essential part showing the state of the substrate at each stage of a production process of a conventional TFT array.

There now follows a description of the preferred embodiments.

The present invention is applicable to both a TFT array having so-called top-gate TFTs, in which gate electrodes are disposed in a layer above that of the channel portions, and a TFT array having so-called bottom-gate TFTs, in which gate electrodes are disposed in a layer below that of the channel portions.

A TFT array having top-gate TFTs can be produced according to the steps 1-A to 1-H below.

### [Step 1-A]

A semiconductor material film is formed over an insulating substrate by sputtering, plasma CVD, plating, or the like.

The substrate may be composed of glass or a synthetic resin. Preferably, an undercoat layer is formed over the substrate before the semiconductor material film is formed. By providing an undercoat layer, the diffusion of trace impurities contained in the substrate, for example, alkali metals when a substrate is made of glass, into the semiconductor layer of each TFT is prevented during the production process and with use of the device. As a result, deterioration of other TFT characteristics caused by an increase in the threshold voltage of the TFTs, a decrease in the effective mobility of the carriers, and the like is prevented.

### [Step 1-B]

By lithography utilizing a first resist, the semiconductor material film is patterned into a shape containing semiconductor layers of the TFTs and pixel electrodes connected thereto.

Specifically, over the semiconductor material film, a resist material is applied by a known method to form a resist layer, and subsequently, the resist layer is exposed using a first mask having a specified pattern. After exposure, the resist layer is developed to form a first resist. Using this first resist as a mask, the semiconductor material film is etched.

### [Step 1-C]

After patterning, an insulating layer (gate insulating film) is formed over the substrate having the semiconductor material film is disposed thereon by, for example, plasma CVD.

Examples of the material for the gate insulating film include SiNₓ, Al₂O₃, MgO, CeO₂, SiO₂, and the like.

### [Step 1-D]

On the insulating layer, gate signal lines and gate electrodes are formed.

Specifically, a first metal layer is formed by sputtering or the like. For the first metal layer, a material is used that has a high conductivity and allows for the formation over its surface of an insulating film that is highly insulative in the subsequent step (1-E). Aluminum or its alloys, for example, aluminum-zirconium alloy, which can be formed into an oxide film having few impurities by anodic oxidation utilizing a neutral solution, may be used. In order to prevent crystallization of aluminum, a layer composed of an alloy is desirable. On the first metal layer, a resist material is applied by a known method to form a resist layer, and the resist layer is exposed using a second mask having a specified pattern. After exposure, the resist layer is developed to form a second resist. Using this second resist as a resist mask, the first metal layer is etched.

### [Step 1-E]

On the top surfaces and side surfaces of the gate electrodes and the gate signal lines, an insulating oxide film is formed. Preferably, the surfaces of the gate electrodes and the gate signal lines are oxidized by anodic oxidation. The anodic oxidation is such that, with the substrate submerged in an electrolyte, voltage is applied between anodes, in this case the gate electrodes and the gate signal lines connected to the gate electrodes, and cathodes to oxidize the surfaces at a low temperature. This method makes it possible to selectively and efficiently form a dense oxide film over only the exposed surfaces of the gate electrodes and the gate signal lines without utilizing a mask.

### [Step 1-F]

With the gate electrodes as a mask, impurities are selectively added to the semiconductor material film to divide the semiconductor material film into regions according to function. Specifically, channel portions (active regions) are formed in the regions directly below the gate electrodes in which impurities are not introduced. Source portions and drain portions are formed in regions in which impurities are introduced so as to sandwich the channel portions. Pixel electrodes connected to the drain portions are formed.

The TFTs formed have a so-called offset construction, as impurities are not added to the regions directly under the insulating oxide films formed over the side surfaces of the gate electrodes. With an offset construction, leakage current is minimal. It should be noted that the addition of an impurity can be carried out before the step 1-E, in which case the so-called on resistance of the TFT is low.

### [Step 1-G]

Using the gate electrodes having the insulating oxide films formed thereon as a mask, an insulating layer is etched to expose the source portions.

### [Step 1-H]

On the substrate having the source portions and the like exposed thereon, source signal lines, connected to the source portions, are formed.

Specifically, a second metal layer is formed by vapor-deposition or the like. The second metal layer material may be composed of, for example, aluminum or aluminum alloys. In the same manner as step 1-D, a resist layer is then formed over the second metal layer. Using a third mask, the resist layer is exposed and developed to form a third resist. Using this third resist as a resist mask, the second metal layer is etched.

On the substrate having the source portions and the like exposed thereon, source signal lines connected to the source portions are formed.

In a TFT array for an IPS-type liquid crystal display panel, common electrodes (counter electrodes) and common electrode lines each connecting common electrodes of a given row are formed.

The following step (1-I) is additionally carried out according to necessity or when desirable.

### [Step 1-I]

A passivation layer is formed over the substrate so as to cover the source signal lines, the TFTs, and the like.

The passivation layer is intended to prevent, in later steps, variance in the characteristics of the TFTs and the like due to external influences or influences from the other elements. When at least a portion of the TFT array is covered with a passivation layer, an array having high reliability and a display device that utilizes this array can be obtained. When the passivation layer is composed of an inorganic substance, reliability is further improved. The passivation layer may be, for example, a layer composed of silicon-based inorganic substances such as a silicon oxide film, a silicon nitride film, or the like. In particular, when a solgel-type silicon compound is employed as the material for the passivation layer, selective formation by a print process is made possible. In particular, in the case of a TFT array for an EL display panel in which a light-emitting layer and a counter electrode are stacked and formed on the pixel electrodes, by disposing a passivation layer over all regions of the TFT array with the exception of regions in which pixel electrodes are disposed, short circuits between the electrodes are prevented and reliability improved.

A TFT array having bottom-gate TFTs can be produced according to the steps 2-A to 2-E below.

### [Step 2-A]

Gate signal lines and gate electrodes are formed on an insulating substrate.

Specifically, a first metal layer is formed over the substrate by sputtering or the like. The first metal layer may be composed of, for example, an aluminum-zirconium alloy. On the first metal layer, a resist material is applied by a known method to form a resist layer, and the resist layer is exposed using a first mask having a specified pattern. After exposure, the resist layer is developed to form a first resist. Using this first resist as a mask, the first metal layer is etched.

Preferably, an undercoat layer is formed over the substrate before the first metal layer is formed.

### [Step 2-B]

On the surface of the substrate having the gate signal lines and the like formed thereon, an insulating layer (gate insulating layer) is formed.

For example, a film composed of silicon oxide, silicon nitride, or the like is formed by plasma CVD.

### [Step 2-C]

On the insulating layer, a semiconductor material film is formed, and this semiconductor material film is processed into the semiconductor layer of the TFTs and conductive elements containing the pixel electrodes.

Specifically, on the substrate having the gate electrodes and the like formed thereon, a semiconductor material film is formed by sputtering, plasma CVD, plating, and the like, and the semiconductor material film is patterned by lithography using a second resist.

Impurities are then added to the semiconductor material film using a mask over the regions where channel portions are to be formed, and thus the semiconductor material film is divided into a plurality of elements according to function. Specifically, channel portions, in which impurities are not introduced, are formed, source and drain portions, in which impurities are introduced, are formed so as to sandwich the channel portions, and pixel electrodes, in which impurities are introduced, are formed so as to be connected to the drain portions.

It should be noted that following the formation of the insulating layer with the formation of the semiconductor material film prevents the intrusion of contaminants between the film and the layer.

After the impurities are injected into the semiconductor material film, the shape of the semiconductor material film may be processed.

In forming light reflective pixel electrodes, it is not necessary to form the pixel electrodes from the semiconductor material film.

### [Step 2-D]

On the insulating layer, source signal lines are formed.

A second metal layer is formed by sputtering or the like. The second metal layer may be composed of, for example, an aluminum-zirconium alloy. On the second metal layer, a resist material is applied by a known method to form a resist layer, and the resist layer is exposed using a third mask having a specified pattern. After exposure the resist layer is developed to form a third resist. Using this third resist as a resist mask, the third metal layer is etched.

When reflective pixel electrodes are formed, the second metal layer is processed to form the pixel electrodes in addition to the source signal lines. In a TFT array for a transflective-type liquid crystal display panel, reflective electrodes, serving as additional pixel electrodes, are formed so as to be electrically connected to the pixel electrodes formed in step 2-C, which are transparent.

In a TFT array for an IPS-type liquid crystal display panel, common electrode (counter electrodes) and common electrode lines each connecting common electrodes of a same given row are formed.

The following step (2-E) is additionally carried out according to necessity or when desirable.

### [Step 2-E]

A passivation layer is formed over the substrate so as to cover the source signal lines, the TFTs, and the like.

The passivation layer is intended to prevent variance in the characteristics of the TFTs and the like due to external influences or influences from the other elements. The passivation layer may be, for example, a layer composed of silica-based inorganic substances such as a silicon oxide film, a silicon nitride film, or the like. In particular, when a solgel-type silicon-based inorganic substance is employed as the material for the passivation layer, selective formation by a print process is made possible.

In the TFT array for an IPS-type liquid crystal display panel, the common electrodes and common electrode lines each connecting common electrodes of a given row may be formed on the passivation layer.

A TFT array having bottom-gate TFTs can also be produced according to the steps 3-A to 3-H below.

### [Step 3-A]

A metal layer is formed over an insulating substrate.

Specifically, a first metal layer is formed by sputtering or the like. The first metal layer may be composed of, for example, an aluminum-zirconium alloy. Preferably, an undercoat layer is formed over the substrate before the first metal layer is formed.

### [Step 3-B]

On the surface of the substrate having the first metal layer formed thereon, an insulating layer (gate insulating film) is formed.

For example, a film composed of silicon oxide, silicon nitride, or the like is formed by plasma CVD. By following the formation of the first metal layer with the formation of an insulating layer, TFTs having stable characteristics can be obtained.

### [Step 3-C]

The first metal layer and the insulating layer are processed into a shape corresponding to source signal lines, gate signal lines, and gate electrodes.

On the insulating layer, a resist material is applied by a known method to form a resist layer, and the resist layer is exposed using a first mask having a specified pattern. After exposure, the resist layer is developed to form a first resist. Using this first resist as a mask, the first metal layer and the insulating layer are etched.

### [Step 3-D]

An insulating oxide film is formed to cover the exposed side surfaces of the gate electrodes and the gate signal lines. Preferably, the surfaces of the gate electrodes and the gate signal lines are oxidized by anodic oxidation. The anodic oxidation is such that, with the substrate submerged in an electrolyte, voltage is applied between anodes, in this case the gate electrodes and the gate signal lines, and cathodes to oxidize the surfaces at a low temperature.

### [Step 3-E]

On the substrate having the gate electrodes and the like formed thereon, a semiconductor material film is formed by sputtering, plasma CVD, plating, or the like.

### [Step 3-F]

The semiconductor material film is divided into the elements of a TFT array.

Impurities are injected into the semiconductor material film using a mask over the regions where channel portions and insulating regions are to be formed.

It should be noted that when light-reflective pixel electrodes are formed, it is not necessary to form the pixel electrodes from the semiconductor film. For example, in step 3-C, the metal layer may be processed to form the pixel electrodes along with the source signal lines and the like. Alternatively, a step of forming pixel electrodes may be added.

In a TFT array for an transflective-type liquid crystal display panel, reflective electrodes, serving as additional pixel electrodes, are formed so as to be electrically connected to the pixel electrodes formed in step 3-F, which are transparent.

In a TFT array for an IPS-type liquid crystal display panel, for example in the processing of the metal layer in step 3-C, common electrodes (counter electrodes) and common electrode lines each connecting common electrodes of a given row are formed.

The following step 3-G is additionally carried out according to necessity or when desirable.

### [Step 3-G]

A passivation layer is provided over the substrate to cover the source signal lines, TFTs, and the like.

In the TFT array for an IPS-type liquid crystal display panel, the common electrodes and common electrode lines each connecting common electrodes of a given row may be formed on the passivation layer.

The TFT arrays fabricated as described above, can be used as the array substrate for a liquid crystal display panel, an EL display panel, or the like.

In a transmissive-type liquid crystal display panel or an EL display panel in which light passes through the pixel electrodes, transparent electrodes formed by processing a semiconductor material are used for the pixel electrodes.

In a reflective-type liquid crystal display panel or an EL display panel in which light passes through the counter electrode, electrodes formed by processing a metal layer are used for the pixel electrodes.

In a transflective-type liquid crystal display panel, both electrodes that are composed of a semiconductor material and electrodes that are composed of metal are used for the pixel electrodes. Various arrangements are possible including, for example,
i) frame-shaped reflective electrodes and transparent electrodes disposed so as to close the openings of the reflective electrodes,
ii) uniformly formed transparent electrodes and a plurality of very small reflective electrodes uniformly disposed and connected to the transparent electrodes, and
iii) uniformly formed transparent electrodes and rectangular reflective metal electrodes disposed such that approximately half of the transparent electrodes are covered.
In particular, when source signal lines are formed over an exposed semiconductor material film, it is possible to simply form the reflective electrodes having a desired shape so as to contact the transparent pixel electrodes.

It is desirable that the reflective electrodes and the transparent electrodes be disposed such that the ratio of the region of the reflective electrodes that contributes to display, i.e. the reflective display region of the pixels, and the region of the transparent electrodes that contributes to display, i.e. the transparent display region, is in the range of 3:1-1:3.

When serving as an array substrate of a liquid crystal display panel, a liquid crystal orientation film for orienting liquid crystal molecules in a specified direction is disposed. The array substrate and a known counter substrate comprising a similar liquid crystal orientation film and a transparent counter electrode are opposed to one another with a liquid crystal layer sandwiched therebetween to form a liquid crystal display panel. On the surface of the counter substrate, a color filter comprising each of R (red), G (green), and B (blue) are disposed according to a specified pattern.

In an organic EL display panel, an electroluminescent layer is directly disposed over the pixel electrodes, and a counter electrode is formed over the electroluminescent layer. For the electroluminescent layer, a known layer such as a single layer light-emitting layer or a layer additionally comprising a hole-transporting layer, an electron-transporting layer, or the like, can be employed. For example, an electroluminescent layer that emits R, G, and B light, respectively, may be disposed according to a specified pattern.

In the following, the preferred embodiments of the present invention are described in detail with reference to the figures.

### EMBODIMENT 1

In the present embodiment, a TFT array utilizing so-called top-gate TFTs in which gate electrodes of the TFTs are disposed in a layer above that of the channel portions is described.

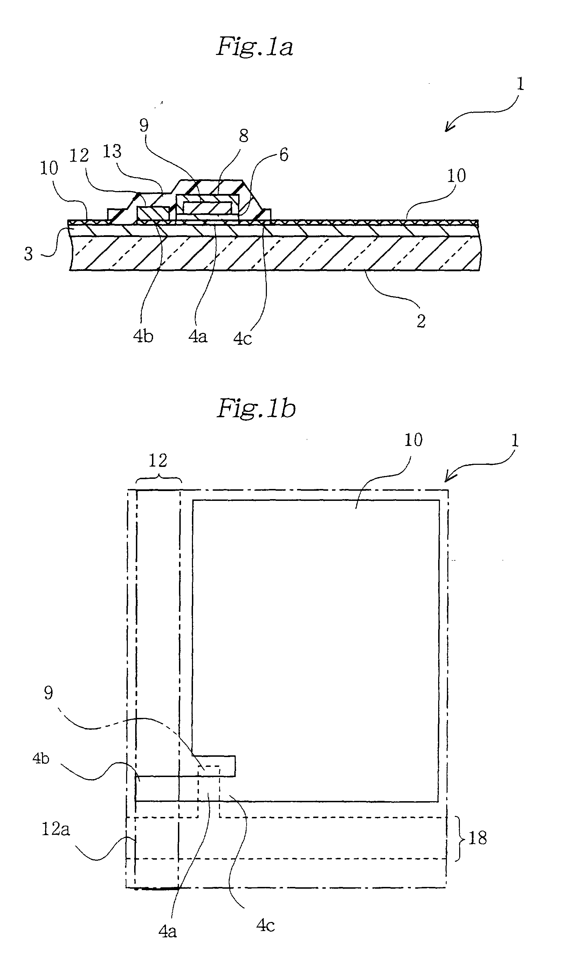

The TFT array of the present embodiment is shown in Figs. 1a and 1b. As shown in the figures, a pixel electrode 10 is disposed in the same layer as that of a channel portion 4a, a source portion 4b, and a drain portion 4c, which serve as the semiconductor layer of each TFT, and the pixel electrode 10 is integrally formed with these portions. The pixel electrode 10, the channel portion 4a, the source portion 4b, and the drain portion 4c are composed of a semiconductor material to which conductivity has been imparted.

The TFT array of the present embodiment is produced in, for example, the following manner.

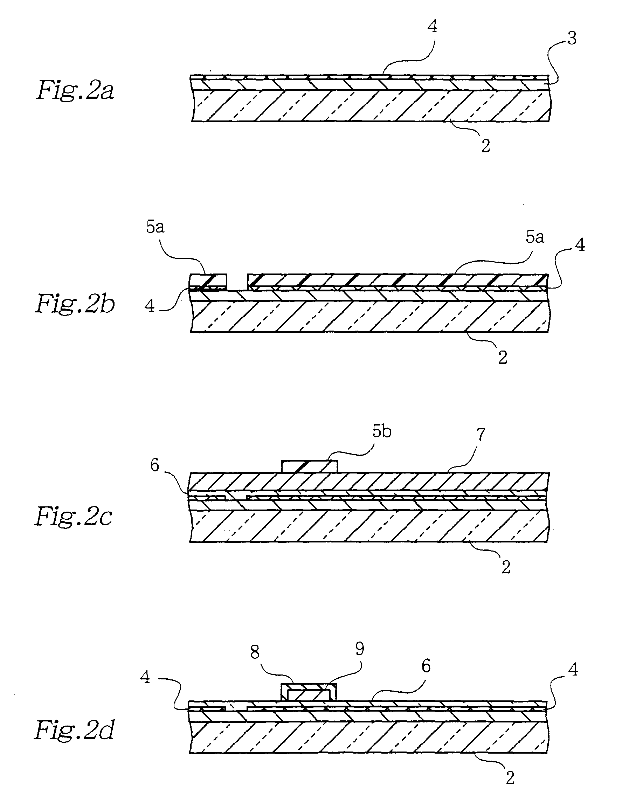

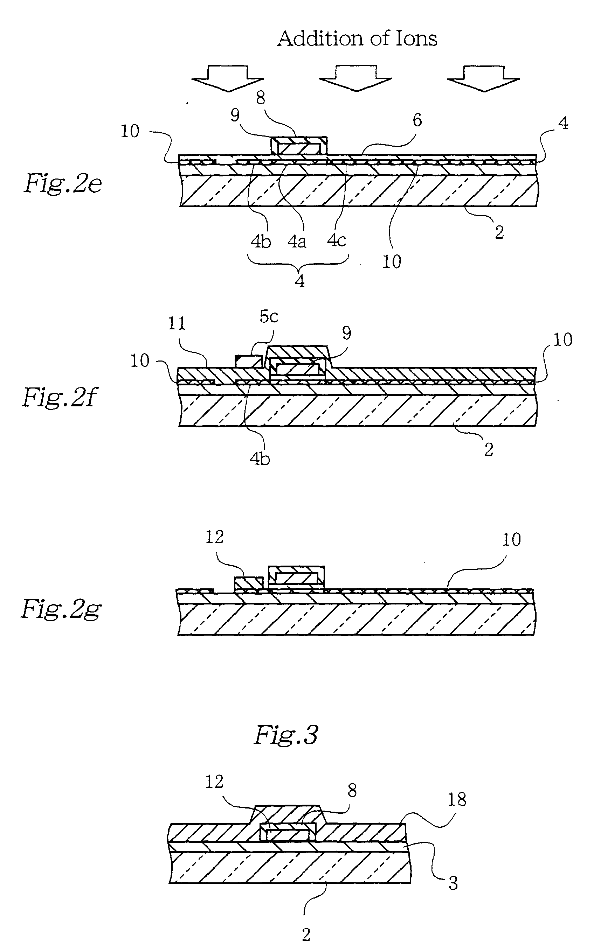

As shown in Fig. 2a, a film composed of silicon oxide and having a thickness of 0.4 µm, serving as an undercoat layer (passivation layer) 3, is formed by chemical vapor deposition (CVD) over a surface of a cleaned, transparent, glass substrate 2, and a transparent semiconductor material film 4 composed of zinc oxide (ZnO) and having a thickness of 50 nm is formed on the undercoat layer by sputtering, plasma CVD, plating, or the like.

A resist material film is formed over the semiconductor material film 4. By exposing and developing the resist material film using a photomask, a resist 5a is formed having a pattern corresponding to the semiconductor layer of each of the thin film transistors and pixel electrodes connected thereto that will be formed. The semiconductor material film 4 is etched using the resist 5a, as is shown in Fig. 2b.

After the resist 5a is removed, as is shown in Fig. 2c, an insulating film 6 composed of silicon nitride and having a thickness of 150 nm is formed by plasma CVD over the substrate 2 having the processed semiconductor material film 4 formed thereon, and a metal layer 7 containing aluminum and zirconium at a weight ratio of 97:3 and having a thickness of approximately 200 nm is formed over the insulating layer 6 by sputtering.

On the metal layer 7, a resist 5b is formed having a pattern corresponding to gate signal lines and gate electrodes that are to be formed. Using the resist 5b, the metal layer 7 is etched.

After the resist 5b is removed, as is shown in Fig. 2d, an insulating layer 8 mainly composed of aluminum oxide is formed on the exposed surfaces of the processed metal layer 7, i.e. on the top and side surfaces, by anodic oxidization utilizing an electrolyte containing ammonium borate and having a pH in the neighborhood of 7. Thus, a plurality (not shown) of gate electrodes 9 and gate signal lines (not shown in the figure), whose perimeters are covered by the insulating layer 6 and the insulating layer 8, are formed.

Using the insulating film 8 as a mask, phosphorus, for example, an n-type impurity, is added to the semiconductor material film 4 at an impurity concentration of 2×10¹⁷ atoms/cm². By the addition of this ion, conductivity is imparted to all of the semiconductor material film 4 except for regions to become channel portions that are covered by the insulating film 8, and thus the semiconductor material film 4 is divided according to function into a plurality (not shown) of channel portions 4a, source portions 4b, drain portions 4c, and pixel electrodes 10 connected to the drain portions 4c.

Using the insulating film 8 as a mask, the insulating layer 6 is etched, whereby the entire insulating layer 6 is removed except for the regions directly below the gate signal lines and the regions directly below the gate electrodes 9.

As is shown in Fig. 2f, a conductive film 11 composed of an aluminum alloy containing 1% by weight of silicon and having a thickness of 0.5 µm is then formed over the substrate 2 having the source portions 4b and the like exposed thereon by the etching. A resist 5c is formed having a pattern corresponding to source signal lines that will be formed. By carrying out etching using this resist 5c, the conductive film 11, as is shown in Fig. 2g, is processed into a plurality (not shown) of source signal lines 12 connected to the source portions 4b that had been exposed by etching.

Though the source signal lines 12 and the gate signal lines 18 intersect, as shown in Fig. 3, the insulation of the signal lines from one another is ensured because the surface of the gate signal lines 18 is covered with the insulating film 8 composed of an oxide.

If necessary, after the resist 5c is removed, a passivation layer 13 composed of silicon nitride is formed by, for example, spin coating over the substrate 2 having the source signal lines 12 formed thereon in the manner described above. Thus, as shown in Fig. 1a and Fig. 1b, a TFT array 1 having top-gate TFTs is obtained. During this process, it is desirable that the passivation layer 13 not be formed in the regions in which the terminals of the signal lines for connecting the TFTs to driver circuits are disposed. It is also of course possible to remove the portion of the passivation layer 13 that is in these regions by etching.

Thus, according to the present embodiment, a TFT array is obtained using only three photomasks.

The production method of the TFT array of the present embodiment is applicable when reflective electrodes are used for the pixel electrodes and when both transparent and reflective electrodes are used as in a TFT array for a transflective-type liquid crystal display panel.

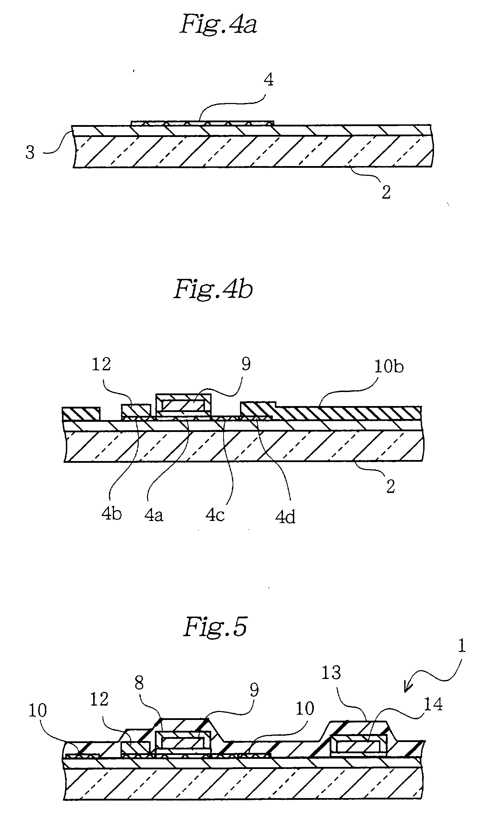

When reflective electrodes are used for the pixel electrodes, the method may be carried out as follows. In the step of processing the semiconductor material film into a shape, the semiconductor material film 4, as is shown in Fig. 4a, is processed into a shape corresponding to channel portions, source portions, and drain portions, or also into a shape containing contact regions contiguous with the drain portions. In the step of forming the source signal lines, the conductive film is not only processed into the source signal lines 12, but also into a plurality (not shown) of reflective pixel electrodes 10b connected to the drain portions 4c or, as is shown in Fig. 4b, a plurality (not shown) of contact regions 4d.

When both transparent electrodes and reflective electrodes are used, for example, in addition to forming transparent pixel electrodes that derive from the semiconductor material film in the manner described above, in the step of processing the conductive film to form source signal lines, reflective pixel electrodes are also formed. In the step of forming the source signal lines, because the surfaces of the transparent pixel electrodes that derive from the semiconductor material film are exposed, it is possible to easily connect the reflective pixel electrodes to be formed to the transparent pixel electrodes.

In a TFT array for a so-called IPS-type liquid crystal display panel, comb-shaped pixel electrodes are used, and common electrodes (counter electrodes) are disposed on the TFT array.

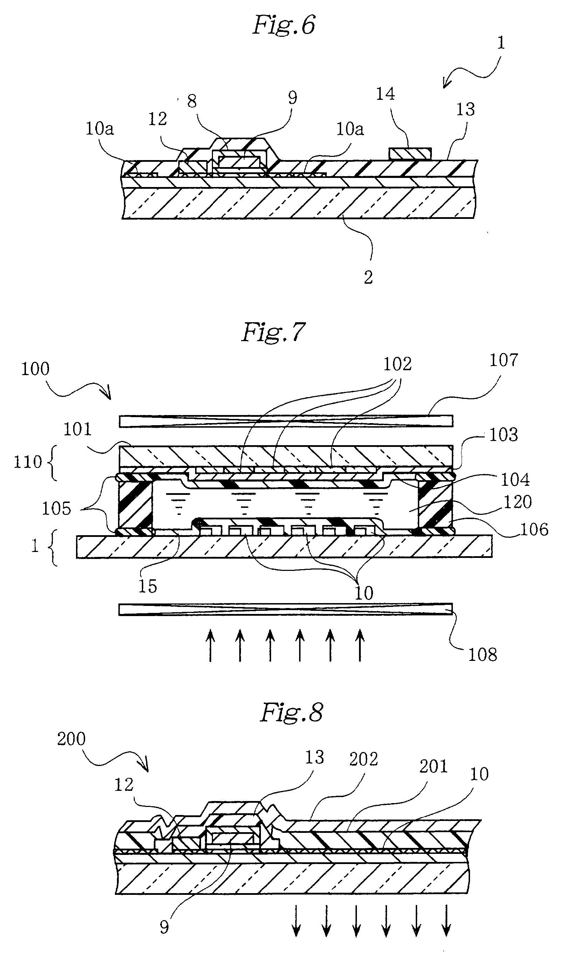

For example, as is shown in Fig. 5, a plurality (not shown) of common electrodes 14 are formed simultaneously with the gate signal lines and the gate electrodes 9. In the step of processing the conductive film into the gate signal lines and the gate electrodes 9, the comb-shaped common electrodes 14, which form pairs with the pixel electrodes 10, are formed simultaneously with common electrode lines (not shown in the figure) for connecting a given row of the common electrodes 14. In the same manner as with the gate electrodes 9, forming an insulating film 8 on exposed surfaces of the common electrodes 14 and the common electrode lines makes it possible to ensure that the source signal lines and the like are insulated. In addition, as is shown in Fig. 6, comb-shaped common electrodes 14 may be disposed on the passivation layer 13. In order to form the common electrodes 14 on the passivation layer 13, although an additional step that utilizes a mask having a specified pattern becomes necessary, the formation of the common electrodes 14 eliminates the need to form a common electrode on the counter substrate, and thus an additional step is not added to the production process of the display panel as a whole.

In the following, display panels employing the TFT array obtained in the manner described above are described.

### I. Liquid Crystal Display Panel

The TFT array of the present embodiment is employed, for example, in a liquid crystal display panel such as that shown in Fig. 7.

In the liquid crystal display panel, as is shown in Fig. 7, a TFT array 1 is opposed to a counter substrate 110 with a liquid crystal layer 120 having a specified thickness disposed therebetween. On the surface of the TFT array 1 and the surface the counter substrate 110 that border with the liquid crystal layer 120, liquid crystal orientation films 15 and 104, respectively, are formed. On a surface on the side of the counter substrate 110 that opposes the TFT array 1, a transparent counter electrode 103 composed of indium tin oxide (ITO) or the like is disposed. In a color liquid crystal display panel, G (green), B (blue), and R (red) color filter layers 102 are disposed on either the TFT array or the counter substrate.

The liquid crystal display panel is produced in, for example, the following manner.

On the passivation layer 13 of the TFT array 1, a polyimide resin material is applied, and the applied film is heat cured to form a polyimide coating film. The surface of the polyimide coating film is rubbed in a fixed direction to form a liquid crystal orientation film. Although the liquid crystal orientation film may be directly formed on the surface of the TFTs and the like without providing a passivation layer, it is desirable to provide a passivation layer in order to prevent the penetration of impurities into the semiconductor layer.

According to a known method, color filter layers 102 are formed on a transparent glass substrate 101, and a counter electrode 103 is then formed on the color filter layer 102. Over the substrate 101 having the counter electrode 103 formed thereon, a silicon oxide film serving as a passivation layer is formed if necessary, and subsequently, a liquid crystal orientation film 104 is formed in the manner described above.

An adhesive 105 is applied to the perimeter of the surface of the counter substrate 110 opposing the TFT array 1 formed in the manner described above and to the corresponding region of the TFT array 1. Spacers 106 are formed on the adhesive 105 of the TFT array 1. The TFT array 1 and the counter substrate 110 are adhered together so that the pixel electrodes 10 and the counter electrode 103 are opposed to one another, and thus, an empty cell having substrates distanced at an interval of, for example, approximately 5 µm is assembled. It should be noted that the orientation treatment direction of the liquid crystal orientation film 15 and that of the liquid crystal orientation film 104 are arranged so as to intersect at 90 degrees. A liquid crystal material (for example, ZLI14792 available from Merck & Co., Inc.) is injected into the empty cell through an opening provided in one of the spacers 106, and subsequently, the opening is closed to form a liquid crystal layer 120. By disposing polarizers 107 and 108 on both outer surfaces so that the polarizers are in a cross nicols relationship, a so-called twisted nematic (TN)-type liquid crystal display panel 100, as is shown in Fig. 7, is obtained. The liquid crystal display panel 100 regulates the transmission of light from a backlight (not shown in figure) applied in the direction of the arrows in the figure, and thus an image is displayed.

### II. Electroluminescent display panel

By forming an electroluminescent layer and a counter electrode on the pixel electrodes of a TFT array of the present embodiment, an electroluminescent (EL) display panel as that shown in Fig. 8 is obtained.

The EL display panel is produced in, for example, the following manner.

On the surface of a TFT array not having a passivation layer formed thereon, a film composed of tris (8-hydroxyquinoline) aluminum, an electroluminescent, green light-emitting material, and having a thickness of approximately 100 nm is formed by, for example, vacuum deposition. By patterning the film into a specified shape, a light-emitting layer 201 that emits green light is formed. By the same method, light-emitting layers (not shown in figure) composed of a red light-emitting material and of a blue light-emitting material are formed.

By forming a metal film composed mainly of aluminum over the substrate having the light-emitting layer 201 formed thereon to serve as, for example, a light-reflective counter electrode 202, an EL display panel 200 as shown in Fig. 8 is obtained. If necessary, a passivation layer may be formed over the counter electrode 202.

In this EL display panel, as the pixel electrodes are transparent electrodes and the counter electrode is a light reflective, light emitted from the light-emitting layer is emitted to the outside as is shown by the arrows in the figure.

When reflective electrodes are used for the pixel electrodes, it is of course possible to use a transparent counter electrode composed of ITO or the like and to emit light from the opposite surface of the substrate.

### EMBODIMENT 2

In the present embodiment, a TFT array utilizing so-called bottom-gate TFTs in which gate electrodes of the TFTs are disposed in a layer below that of the channel portions is described.

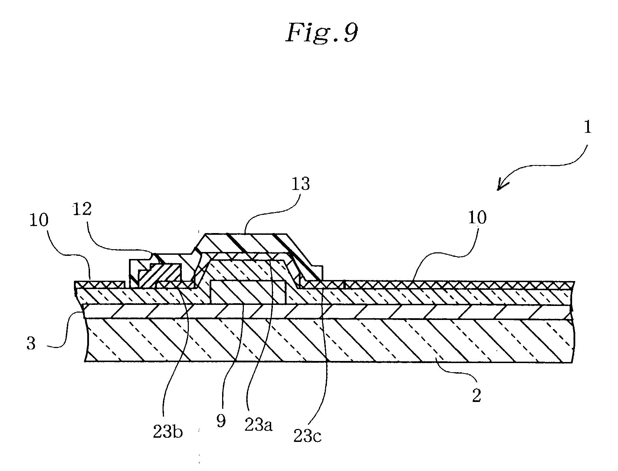

The TFT array of the present embodiment is shown in Fig. 9. As is shown in the figure, a pixel electrode 10 is disposed in the same layer as that of a channel portion 23a, a source portion 23b, and a drain portion 23c, which serve as the semiconductor layer of a TFT, and the pixel electrode 10 is integrally formed with these portions. The pixel electrode 10, the channel portion 23a, the source portion 23b, and the drain portion 23c are composed of a semiconductor material to which conductivity has been imparted.

The TFT array of the present embodiment is produced in, for example, the following manner.

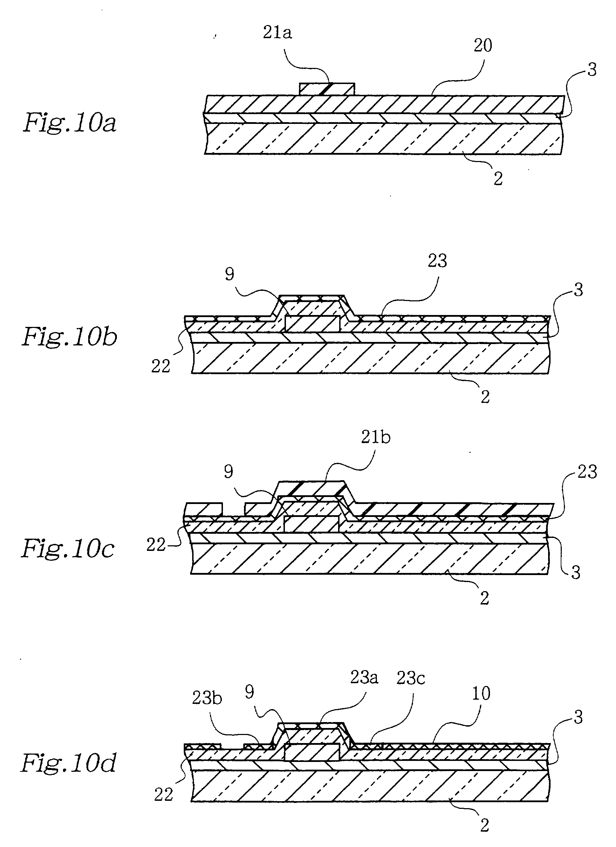

As shown in Fig. 10a, a film composed of silicon oxide and having a thickness of 0.4 µm, serving as an undercoat layer 3, is formed by chemical vapor deposition (CVD) over a surface of a cleaned, transparent, glass substrate 2, and a metal layer 20 having a thickness of approximately 200 nm and containing aluminum and zirconium at a weight ratio of 97:3 is formed on the undercoat layer 3 by sputtering. On the metal layer 20, by forming a resist material film, exposing the resist material film using a photomask, and developing the resist material film, a resist 21a is formed having a pattern corresponding to gate electrodes and gate signal lines to be formed. By etching with the resist 21a as a mask, the metal layer 20 is processed into a plurality (not shown) of gate electrodes 9 and gate signal lines (not shown in figure).

After the resist 21a is removed, as is shown in Fig. 10b, an insulating layer 22 composed of silicon nitride and having a thickness of 150 nm is formed by plasma CVD over the surface of the substrate 2 having the gate electrodes 9 formed thereon, and a transparent semiconductor material film 23 composed of zinc oxide (ZnO) and having a thickness of 50 nm is formed on the insulating layer 22 by sputtering, plasma CVD, plating, or the like.

As shown in Fig. 10c, on the semiconductor material film 23, a resist 21b is formed having a pattern corresponding to the semiconductor layer of each thin film transistor and to pixel electrodes to be formed. Using the resist 21b, the semiconductor material film 23 is etched.

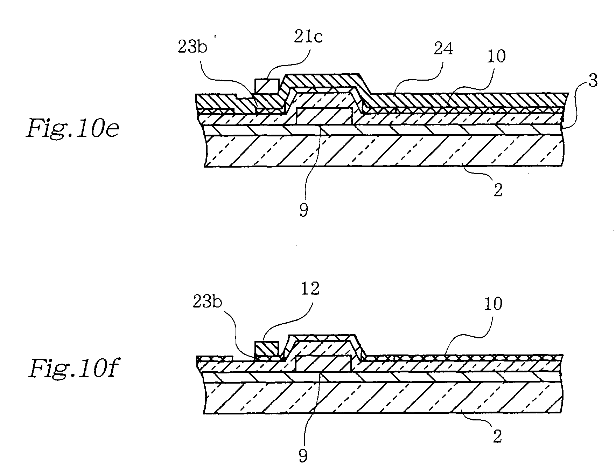

Before or after the semiconductor material film 23 is processed, phosphorus, an n-type impurity, is added using a mask to the semiconductor material film 23 at an impurity concentration of, for example, 2×10¹⁷ atoms/cm². By adding this impurity, conductivity is imparted to all of the semiconductor material film 23 except to regions covered by the mask to be formed into channel portions, and as is shown in Fig. 10d, the semiconductor material film 23 is divided according to function into a plurality (not shown) of channel portions 23a, source portions 23b, drain portions 23c, and pixel electrodes 10 connected to the drain portions 23c. As is shown in Fig. 10e, over the substrate 2 having source portions 23b and the like formed thereon, a conductive film 24 composed of an aluminum alloy containing 1% by weight of silicon and having a thickness of 0.5 µm is then formed, and on top of this, a resist 21c is formed having a pattern corresponding to source signal lines to be formed.

By etching with the resist 21c, the conductive film 24 is processed, as shown in Fig. 10f, into a plurality (not shown) of source signal lines 12 connected to the source portions 23b exposed by the etching.

If necessary, after the resist 21c is removed, a passivation layer 13 composed of silicon nitride is formed by, for example, spin coating over the substrate 2 having the source signal lines 12 formed thereon. Thus, as shown in Fig. 9, a TFT array 1 having bottom-gate TFTs is obtained.

It is desirable that the passivation layer 13 not be formed in the regions in which the terminals of the signal lines for connecting the TFTs to a driver circuit are disposed. It is also of course possible to remove the portion of the passivation layer 13 that is these regions by etching. By removing the passivation layer 13 that is formed on the surface of the gate signal lines, the gate signal lines are exposed.

Thus, according to the present embodiment, a TFT array is obtained using only three photomasks.

The production method of the TFT array of the present embodiment is applicable when reflective electrodes are use for the pixel electrodes and when both transparent and reflective electrodes are used as in a TFT array for a transflective-type liquid crystal display panel.

When reflective electrodes are used for the pixel electrodes, the method may be carried out as follows. In the step of processing the semiconductor material film into a predetermined shape, the semiconductor material film is processed into a shape corresponding to a plurality (not shown) of channel portions 23a, source portions 23b, and drain portions 23c, or also into a shape containing contact regions contiguous with the channel portions 23a. In the step of forming the source signal lines, the conductive film is not only processed into the source signal lines 12, but also into reflective pixel electrodes connected to the drain portions 23c or the contact regions.

When both transparent electrodes and reflective electrodes are used, for example, in addition to forming transparent pixel electrodes that derive from the semiconductor material film in the manner described above, in the step of processing the conductive film to form source signal lines, reflective pixel electrodes are also formed. In the step of forming the source signal lines, because the surfaces of the transparent pixel electrodes are exposed, it is possible to easily connect the reflective pixel electrodes to be formed to the transparent pixel electrodes.

In a TFT array for a so-called IPS-type liquid crystal display panel, comb-shaped pixel electrodes are used, and in the step of processing the conductive film into gate signal lines and gate electrodes, comb-shaped common electrodes, which form pairs with the pixel electrodes, and common electrode lines for connecting the common electrodes of a given row are also formed. By forming an insulating layer on exposed surfaces of the common electrodes and the common electrode lines, as was done with the gate signal lines and the like, insulation of the common electrodes and the common electrode lines from the source signal lines and the like is ensured. In addition, the common electrodes may be formed on a passivation layer. In order to form the comb-shaped common electrodes on the passivation layer, although an additional step that utilizes a mask having a specified pattern becomes necessary, the formation of the common electrodes eliminates the need to form a common electrode on the counter substrate, and thus an additional step is not added to the production process of the display panel as a whole.

### EMBODIMENT 3

In the present embodiment, an example of a TFT array that utilizes a semiconductor material film for insulating elements is described.

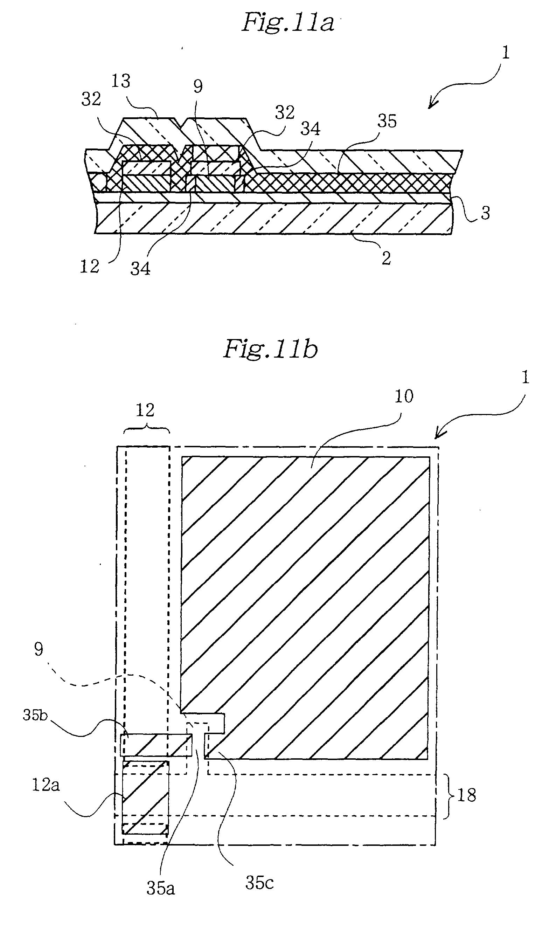

The TFT array of the present embodiment is shown in Fig. 11a and Fig. 11b. In the present embodiment, the semiconductor material film is divided according to function into components of the TFT array without the shape of the film being processed. In addition, the principal elements of a plurality (not shown) of gate signal lines 18, gate electrodes 9, and source signal lines 12 are formed by processing a single layer. Therefore, the production process of the TFT array is simplified even further in comparison with the embodiments described above.

The TFT array of the present embodiment is produced in, for example, the following manner.

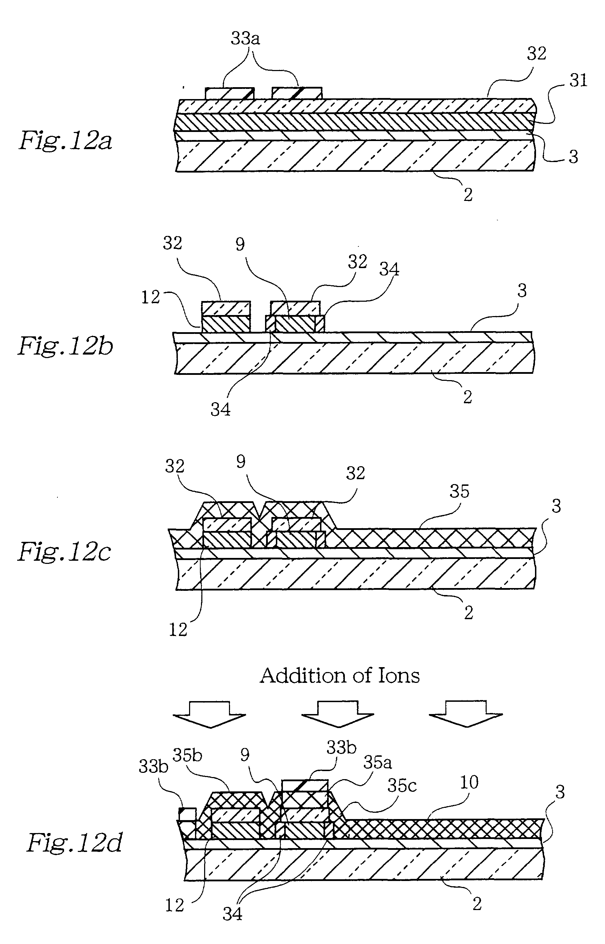

As shown in Fig. 12a, a film composed of silicon oxide and having a thickness of 0.4 µm, serving as an undercoat layer 3, is formed by chemical vapor deposition (CVD) over a surface of a cleaned, transparent, glass substrate 2, and an alloy film 31 having a thickness of approximately 200 nm and containing aluminum and zirconium at a weight ratio of approximately 97:3 is formed on the undercoat layer 3 by sputtering. On the surface of the alloy film 31, an insulating layer 32 composed of silicon nitride and having a thickness of 150 nm is formed.

On the surface of the insulating layer 32, a resist layer 33a for photolithography is formed having a pattern corresponding to the shape of gate electrodes, gate signal lines, and source signal lines to be formed by processing the alloy film 31.

Subsequently, by etching, the alloy film 31 and the insulating layer 32 are processed into a pattern corresponding to the shape of the resist layer 33a. By this etching, the alloy film 31 is processed into a shape corresponding to gate electrodes, gate signal lines, and line-segment members of source signal lines. After removing the resist layer 33a, anodic oxidation is carried out utilizing an electrolyte containing ammonium borate and having a pH in the neighborhood of 7, whereby, as is shown in Fig. 12b, gate electrodes and gate signal lines provided with an insulating film 34 composed of aluminum oxide on exposed side surfaces are formed.

As shown in Fig. 12c, over the substrate 2 having gate electrodes 9 and the like disposed thereon, a semiconductor material film 35 composed of zinc oxide and having a thickness of 70 nm is formed by, for example, sputtering. Zinc oxide is a so-called i-type semiconductor, and thus, the formed semiconductor material film 35 transmits visible light. When a p-type impurity, for example, when a small dose of boron is added to the semiconductor material film 35 an impurity concentration of approximately 2×10¹² atoms/cm², the film 35 shows stable conductivity.

As is shown in Fig. 12d, a resist layer 33b is formed having a pattern over the regions in which insulating elements and a channel portion of each thin film transistor are to be processed, and using this as a mask, phosphorus, an n-type impurity, is added at an impurity concentration of, for example, 2×10¹⁷ atoms/cm². By adding this impurity, a channel portion 35a, a source portion 35b, and a drain portion 35c of a plurality (not shown) of semiconductor layers, are formed simultaneously with a plurality (not shown) of pixel electrodes 10. In addition, as is shown in Fig. 13, a plurality (not shown) of connecting members 33d for electrically connecting a plurality (not shown) of segmented source signal lines 12 are formed in regions of intersection with the gate signal lines 18.

The resist layer 33b is removed, and if necessary, a passivation layer 13 is formed. A TFT array 1 as shown in Fig. 11a and Fig. 11b is thus obtained.

It should be noted that in order to facilitate the removal of the resist from the substrate 2, it is possible to uniformly form an inorganic insulating film such as a silicon oxide film and subsequently, to process this inorganic insulating film into a mask for adding the impurity by using the resist to carry out etching, and finally to add the impurity to the region to form the active layer of the semiconductor material film using this mask.

For example, the impurity added is activated by lamp annealing, to form the active layer of each thin film transistor.

In the manner described above, thin film transistors are formed on a substrate 2 in a matrix, and signal lines connected to each thin film transistor are formed.

## Claims

1. A thin film transistor array comprising:
an insulating substrate;
thin film transistors disposed on the substrate in a matrix, each of the thin film transistors comprising a semiconductor layer having a channel portion, a source portion, and a drain portion;
source signal lines each for supplying a source signal to a given column of the thin film transistors;
gate signal lines each for supplying a gate signal to a given row of the thin film transistors; and
pixel electrodes each connected to the drain portion of one of the thin film transistors;
wherein the pixel electrodes contain a semiconductor material the same as a material of the semiconductor layer of each of the thin film transistors.

2. The thin film transistor array according to claim 1, wherein the semiconductor layer of each of the thin film transistors is integrally formed with one of the pixel electrodes.

3. The thin film transistor array according to claim 1, wherein the semiconductor layers, the pixel electrodes, and insulating elements for separating the pixel electrodes from one another are included in a single semiconductor material film.

4. The thin film transistor array according to claim 1, wherein the semiconductor material is light transmissive.

5. The thin film transistor array according to claim 1, wherein the semiconductor material is an oxide semiconductor.

6. The thin film transistor array according to claim 5, wherein the oxide semiconductor is an oxide selected from the group consisting of zinc oxide, zinc-magnesium oxide, zinc-cadmium oxide, and cadmium oxide.

7. The thin film transistor array according to claim 1, wherein the semiconductor layer of each of the thin film transistors is directly connected to one of the source signal lines.

8. The thin film transistor array according to claim 1, wherein with the exception of regions of intersection between the gate signal lines and the source signal lines, the gate signal lines and the source signal lines comprise a same material and are disposed in a same layer.

9. The thin film transistor array according to claim 8, wherein one of a) the gate signal lines and b) the source signal lines comprise:
line-shaped members disposed in regions other than the regions of intersection; and
connection members for connecting the line-shaped members, the connection members containing a semiconductor material the same as the semiconductor material contained in the pixel electrodes and the line-shaped members being disposed between the other of the signal lines.

10. The thin film transistor array according to claim 1, wherein the gate signal lines and the source signal lines are insulated from one another in regions of intersection by an insulating oxide film formed on a surface of each of either the gate signal lines or the source signal lines.

11. The thin film transistor array according to claim 1, wherein the pixel electrodes are comb-shaped, and the array further comprises comb-shaped counter electrodes disposed on the substrate, each forming a pair with one of the pixel electrodes.

12. The thin film transistor array according to claim 11, wherein the counter electrodes are disposed in a same layer as a layer of either the gate signal lines or the source signal lines.

13. The thin film transistor array according to claim 12, wherein each of the counter electrodes is disposed in a same layer as a layer of the gate signal lines and has an insulating oxide film on a surface thereof.

14. The thin film transistor array according to claim 11, wherein the counter electrodes are disposed in a layer above a layer of the pixel electrodes with an insulating layer disposed therebetween.

15. The thin film transistor array according to claim 1, wherein the pixel electrodes are light transmissive, and the array further comprises additional pixel electrodes electrically connected to the pixel electrodes, the additional pixel electrodes being light reflective.

16. The thin film transistor array according to claim 1, wherein a gate electrode of each of the thin film transistors has an insulating oxide film on a surface thereof.

17. The thin film transistor array according to claim 1, further comprising an undercoat layer formed over a surface on a side of the substrate having the thin film transistors formed thereon.

18. A thin film transistor array comprising:
an insulating substrate;
thin film transistors disposed on the substrate in a matrix, each of the thin film transistors comprising a semiconductor layer having a channel portion, a source portion, and a drain portion;
source signal lines each for supplying a source signal to a given column of the thin film transistors;
gate signal lines each for supplying a gate signal to a given row of the thin film transistors; and
pixel electrodes each connected to the drain portion of one of the thin film transistors;
wherein the source portions and the drain portions are directly connected to the source signal lines and the pixel electrodes, respectively, the source signal lines and the pixel electrodes being composed of the same material.

19. The thin film transistor array according to claim 18, wherein the source signal lines and the pixel electrodes are composed of aluminum or an aluminum alloy.

20. The thin film transistor array according to claim 18, wherein counter electrodes are disposed in a layer above a layer of the pixel electrodes with an insulating layer disposed therebetween.

21. The thin film transistor array according to claim 18, further comprising an undercoat layer formed over a surface on a side of the substrate having the thin film transistors formed thereon.

22. A method of producing a thin film transistor array, comprising an insulating substrate; thin film transistors disposed on the substrate in a matrix, each of the thin film transistors comprising a semiconductor layer having a channel portion, a source portion, and a drain portion; source signal lines each for supplying a source signal to a given column of the thin film transistors; gate signal lines each for supplying a gate signal to a given row of the thin film transistors; and pixel electrodes each connected to the drain portion of one of the thin film transistors, the method comprising processing a semiconductor material film formed over the substrate into a plurality of elements including pixel electrodes and a semiconductor layer of each of the thin film transistors by adding a p-type impurity or an n-type impurity to specified regions of the semiconductor material film.

23. The method of producing a thin film transistor array according to claim 22, wherein the semiconductor material film is composed of an oxide semiconductor.

24. The method of producing a thin film transistor array according to claim 23, wherein the oxide semiconductor is an oxide selected from the group consisting of zinc oxide, zinc-magnesium oxide, zinc-cadmium oxide, and cadmium oxide.

25. The method of producing a thin film transistor array according to claim 22, wherein thermal diffusion utilizing, as a diffusion source, a conductive element connected to the semiconductor material film and formed in advance is employed to diffuse a constituent element of the conductive element into specified regions of the semiconductor material film.

26. The method of producing a thin film transistor array according to claim 22, wherein, before the adding of the impurity, the semiconductor material film contains a specified amount of an impurity.

27. A method of producing a thin film transistor array according to claim 22, comprising the steps of:
forming a semiconductor material film over the substrate;
processing the semiconductor material film into a shape containing regions where semiconductor layers of thin film transistors and pixel electrodes connected to the semiconductor layers are to be formed;
forming an insulating layer over the processed semiconductor material film;
forming a metal film over the insulating layer;
processing the metal film into a shape of a) gate electrodes over regions of the semiconductor material film where channel portions are to be formed and b) gate signal lines connected to the gate electrodes;
forming an insulating oxide film over exposed surfaces of the processed metal film to obtain gate electrodes and gate signal lines;
processing the semiconductor material film into channel portions, source portions, drain portions, and pixel electrodes by adding a p-type or n-type impurity to the semiconductor material film using the gate electrodes as a mask;
forming a conductive film over the substrate having the processed semiconductor material film formed thereon; and
processing the conductive film to form source signal lines connected to the source portions.

28. The method of producing a thin film transistor array according to claim 27, wherein in the step of processing the conductive film, the conductive film is processed to also form additional pixel electrodes connected to the pixel electrodes.

29. The method of producing a thin film transistor array according to claim 27, wherein the pixel electrodes are comb-shaped, and in the step of processing the metal film, the metal film is processed to also form comb-shaped counter electrodes, each forming a pair with one of the pixel electrodes.

30. The method of producing a thin film transistor array according to claim 27, wherein the insulating oxide film is formed by anodic oxidation.

31. The method of producing a thin film transistor array according to claim 27, wherein the metal film is composed of aluminum or an aluminum alloy.

32. The method of producing a thin film transistor array according to claim 27, further comprising a step of forming an undercoat layer comprising an inorganic substance over the substrate before the step of forming a semiconductor material film.

33. The method of producing a thin film transistor array according to claim 27, further comprising a step of forming a passivation layer comprising an inorganic substance over the substrate having the source signal lines formed thereon.

34. The method of producing a thin film transistor array according to claim 22, comprising the steps of:
forming a conductive film over the substrate;
processing the conductive film to form gate electrodes of the thin film transistors and gate signal lines connected to the gate electrodes;
forming an insulating film over the substrate having the gate electrodes and the gate signal lines formed thereon;
forming a semiconductor material film over the insulating film;
processing the semiconductor material film into a shape containing regions where semiconductor layers of the thin film transistors and pixel electrodes connected to the semiconductor layers are to be formed;
processing the semiconductor material film into channel portions, source portions, drain portions, and pixel electrodes by adding a p-type or n-type impurity into the semiconductor material film using a mask over regions where the channel portions of the semiconductor layers are to be formed;
forming a conductive film over the substrate having the processed semiconductor material film formed thereon; and
processing the conductive film to form source signal lines connected to the source portions.

35. The method of producing a thin film transistor array according to claim 34, wherein in the step of processing the conductive film, the conductive film is processed to also form additional pixel electrodes connected to the pixel electrodes.

36. The method of producing a thin film transistor array according to claim 34, wherein the pixel electrodes are comb-shaped, and in the step of processing the metal film, the metal film is processed to also form comb-shaped counter electrodes, each forming a pair with one of the pixel electrodes.

37. The method of producing a thin film transistor array according to claim 34, wherein:
the pixel electrodes are comb-shaped; and
the method further comprises:
forming an insulating layer over the substrate having the source signal lines formed thereon; and
forming comb-shaped counter electrodes on the insulating layer, each forming a pair with one of the pixel electrodes.

38. The method of producing a thin film transistor array according to claim 34, further comprising a step of forming an undercoat layer composed of an inorganic substance over the substrate before the step of forming a conductive film.

39. The method of producing a thin film transistor array according to claim 34, further comprising a step of forming a passivation layer composed of an inorganic substance over the substrate having the source signal lines formed thereon.

40. The method of producing a thin film transistor array according to claim 22, comprising the steps of:
forming a metal film over the substrate;
forming an insulating film over the substrate having the metal film formed thereon;
processing the metal film and the insulating film into a pattern substantially corresponding to gate signal lines, gate electrodes connected to the gate signal lines, and components of source signal lines not in regions of intersection with the gate signal lines;
forming an insulating oxide film by oxidizing exposed side surfaces of the metal film from which the gate signal lines and the gate electrodes are to be processed, whereby the gate signal lines and the gate electrodes are obtained;
forming a semiconductor material film over the substrate;
forming channel, portions and pixel electrodes by adding a p-type or n-type impurity to the semiconductor material film using a mask over regions where the channel portions are to be formed, the mask having openings for regions where the pixel electrodes and the members connecting the components of the source signal lines are to be formed.

41. The method of producing a thin film transistor array according to claim 40, wherein:
the pixel electrodes are comb-shaped, and in the step of processing the metal film and the insulating film, the metal film is processed to also form comb-shaped counter electrodes, each forming a pair with one of the pixel electrodes; and
in the step of forming channel regions and pixel electrodes, connecting members for electrically connecting a plurality of the counter electrodes to one another are also formed.

42. The method of producing a thin film transistor array according to claim 40, wherein;
the pixel electrodes are comb-shaped; and
the method further comprises the steps of:
forming a passivation layer over the substrate having the pixel electrodes formed thereon; and
forming counter electrodes on the passivation layer, each forming a pair with one of the pixel electrodes.

43. The method of producing a thin film transistor array according to claim 40, wherein the insulating oxide film is formed by anodic oxidation.

44. The method of producing a thin film transistor array according to claim 40, wherein the metal film is composed of aluminum or an aluminum alloy.

45. The method of producing a thin film transistor array according to claim 40, further comprising a step of forming an undercoat layer composed of an inorganic substance over the substrate before the step of forming a metal film.

46. The method of producing a thin film transistor array according to claim 40, further comprising a step of forming a passivation layer composed of an inorganic substance over the substrate having the pixel electrodes formed thereon.

47. A method of producing a thin film transistor array comprising an insulating substrate; thin film transistors disposed on the substrate in a matrix, each of the thin film transistors comprising a semiconductor layer having a channel portion, a source portion, and a drain portion; source signal lines each for supplying a source signal to a given column of the thin film transistors; gate signal lines each for supplying a gate signal to a given row of the thin film transistors; and pixel electrodes each connected to the drain portion of one of the thin film transistors, wherein source signal lines and pixel electrodes are formed so as to be directly connected to exposed source portions and drain portions of semiconductor layers formed on the substrate.

48. The method of producing a thin film transistor array according to claim 47, comprising the steps of:
forming a semiconductor material film over the substrate;
processing the semiconductor material film into a shape containing regions where semiconductor layers of thin film transistors are to be formed;
forming an insulating layer over the processed semiconductor material film;
forming a metal film over the insulating layer;
processing the metal film into a shape of a) gate electrodes of the thin film transistors over regions of the semiconductor material film where channel portions are to be formed and b) gate signal lines connected to the gate electrodes;
forming an insulating oxide film over exposed surfaces of the processed metal film to obtain gate electrodes and gate signal lines;
processing the semiconductor material film into channel portions, source portions, and drain portions by adding a p-type or n-type impurity to the semiconductor material film using the gate electrodes as a mask;
forming a conductive film over the substrate having the processed semiconductor material film formed thereon; and
processing the conductive film to form source signal lines connected to the source portions and pixel electrodes directly connected to the drain portions.

49. The method of producing a thin film transistor array according to claim 48, wherein the pixel electrodes are comb-shaped; and
the method further comprises the steps of:
forming an insulating layer over the substrate having the pixel electrodes formed thereon; and
forming comb-shaped counter electrodes, each forming a pair with one of the pixel electrodes, over the insulating layer.

50. The method of producing a thin film transistor array according to claim 48, wherein the insulating oxide film is formed by anodic oxidation.

51. The method of producing a thin film transistor array according to claim 48, wherein the metal film is composed of aluminum or an aluminum alloy.

52. The method of producing a thin film transistor array according to claim 48, further comprising a step of forming an undercoat layer composed of an inorganic substance over the substrate before the step of forming a semiconductor material film over the substrate.

53. The method of producing a thin film transistor array according to claim 48, further comprising a step of forming a passivation layer composed of an inorganic substance over the substrate having the pixel electrodes formed thereon.

54. The method of forming a thin film transistor array according to claim 47, comprising the steps of:
forming a conductive film over the substrate;
processing the conductive film to form gate electrodes of thin film transistors and gate signal lines connected to the gate electrodes;
forming an insulating film over the substrate having the gate electrodes and the signal lines formed thereon;
forming a semiconductor material film over the insulating film;
processing the semiconductor material film into a shape containing regions where the semiconductor layers of the thin film transistors are to be formed;
processing the semiconductor material film into channel portions, source portions, and drain portions by adding a p-type or n-type impurity to the semiconductor material film using a mask over regions where the channel portions of the thin film transistors are to be formed;
forming a conductive film over the substrate having the processed semiconductor material film formed thereon; and
processing the conductive film into a specified pattern to form source signal lines connected to the source portions and pixel electrodes connected to the drain portions.

55. The method of producing a thin film transistor array according to claim 54, wherein the pixel electrodes are comb-shaped; and
the method further comprises the steps of:
forming an insulating layer over the substrate having the pixel electrodes formed thereon; and
forming comb-shaped counter electrodes on the insulating layer, each forming a pair with one of the pixel electrodes.

56. The method of forming a thin film transistor array according to claim 54, further comprising the step of forming an undercoat layer composed of an inorganic substance over the substrate before the step of forming a conductive film over the substrate.

57. The method of producing a thin film transistor array according to claim 54, further comprising a step of forming a passivation layer composed of an inorganic substance over the substrate having the pixel electrodes formed thereon.

58. A display panel comprising an array substrate, a counter substrate, and a liquid crystal layer sandwiched between the array substrate and the counter substrate, the array substrate comprising:
an insulating substrate;
thin film transistors disposed on the substrate in a matrix, each of the thin film transistors comprising a semiconductor layer having a channel portion, a source portion, and a drain portion;
source signal lines each for supplying a source signal to a given column of the thin film transistors;
gate signal lines each for supplying a gate signal to a given row of the thin film transistors; and
pixel electrodes each connected to the drain portion of one of the thin film transistors and containing a semiconductor material the same as a material of the semiconductor layer of each of the thin film transistors.

59. A display panel comprising:
an insulating substrate;
thin film transistors disposed on the substrate in a matrix, each of the thin film transistors comprising a semiconductor layer having a channel portion, a source portion, and a drain portion;
source signal lines each for supplying a source signal to a given column of the thin film transistors;
gate signal lines each for supplying a gate signal to a given row of the thin film transistors;
pixel electrodes each connected to the drain portion of one of the thin film transistors and containing a semiconductor material the same as a material of the semiconductor layer of each of the thin film transistors;
an electroluminescent layer stacked on the pixel electrodes; and
a counter electrode stacked on the electroluminescent layer.
